# EUROPÄISCHE PATENTSCHRIFT

(11) **EP 2 580 538 B1**
(45) Veröffentlichungstag und Bekanntmachung des Hinweises auf die Patenterteilung: **30.09.2015**
(21) Anmeldenummer: 11724516.7
(22) Anmeldetag: 23.05.2011
(51) Int. Cl.: F24J 2/00, F24J 2/50, F24J 2/05, F24J 2/14, F24J 2/26, F24J 2/32, F24J 2/34, H01L 31/052, F24J 2/54, H01L 31/0352, H02S 40/44, H01L 31/054

(54) **KOMBI-SOLARKOLLEKTOR**
COMBINED SOLAR COLLECTOR
COLLECTEUR SOLAIRE COMBINÉ

(30) Priorität: 11.06.2010 AT 9562010
(43) Veröffentlichungstag der Anmeldung: 17.04.2013
(73) Patentinhaber: Ferschitz, Reinold, 2460 Bruck an der Leitha (AT)
(72) Erfinder: Ferschitz, Reinold, 2460 Bruck an der Leitha (AT)
(74) Vertreter: Sonn & Partner Patentanwälte
(86) Internationale Anmeldenummer: PCT/AT2011/000235
(87) Internationale Veröffentlichungsnummer: WO 2011/153561

(56) Entgegenhaltungen:
- DE-A1- 4 323 270
- DE-A1- 19 709 653

## Beschreibung

Die Erfindung betrifft einen Kombi(Kombinations)-Solarkollektor gemäß dem Oberbegriff von Anspruch 1.

Aus der DE 43 23 270 A1 ist ein Kombi Sorarkollektor mit einer Blechwanne bekannt, in der ein Absorber mit Leitungen für ein zu erwärmendes Medium angeordnet ist; diese Blechwanne ist an der Oberseite von einer Strahlungs-durchlässigen Scheibe abgeschlossen, an deren Innenseite Photovoltaikzellen, beispielsweise durch Heißkleben, aufgebracht sind. In einer Ausführungsform sind dabei Photovoltaik und Absorber in einem gemeinsamen Raum angeordnet.

Aus der JP 57-192745A ist ein Kombi-Solarkollektor bekannt, bei dem zwei koaxiale lichtdurchlässige Rohre vorgesehen sind, die an ihren Enden miteinander verbunden sind; das innere Rohr trägt auf einem Teil seines Außenumfangs ein Photovoltaikelement; im Inneren des inneren Rohrs ist weiters ein Wärmetauscherrohr angeordnet.

Aus der DE 197 09 653 C2 ist ein Kombi-Solarkollektor mit einer Vakuumröhre, in der sich ein Absorber mit daran angebrachtem, von einem Fluid durchströmbaren Wärmerohr befindet, und mit einem Photovoltaikelement, wobei der Kombi-Solarkollektor drehbar gelagert ist, bekannt. Durch die Verdrehbarkeit des Kombi-Solarkollektors kann dieser dem Sonnenstand entsprechend nachgeführt werden. Eine unabhängige Nachführung entweder nur des Absorbers oder nur des Photovoltaikelementes ist nicht möglich.

Aus der DE 43 38 735 ist ein verdrehbarer Kombi-Solarkollektor bekannt, bei dem die Wärme von einem in einer Vakuumröhre angeordneten Kollektorblech über eine Wärmeleitung nach außen abgeführt wird. Die Beaufschlagung von zwei Photovoltaikelementen erfolgt über ein Spiegelsystem. Ein wesentlicher Nachteil dieses Kollektors liegt darin, dass die Erzeugung von Wärme nur mit einem sehr geringen Wirkungsgrad erfolgt, da der Wärmetransport durch Wärmeleitung mit großen Verlusten verbunden ist.

Weiter sind Photovoltaikmodule bekannt, bei denen an Glastafeln Photovoltaikdünnschichtmodule aufgedampft sind.

Aufgabe der Erfindung ist es, einen Kombi-Solarkollektor zu schaffen, bei dem eine Erhöhung der Stromausbeute bzw. der thermischen Leistung, bei entsprechender Reduktion der Ausbeute der jeweils anderen Energieform, möglich ist.

Diese Aufgabe wird beim Kombi-Solarkollektor der eingangs angeführten Art durch die im kennzeichnenden Teil des Anspruches 1 angegebenen Merkmale gelöst.

Zur Verdrehung des Kombi-Solarkollektors ist vorteilhafterweise ein Schrittmotor angeordnet. Weiters ist es günstig, wenn zur Steuerung der Verdrehung der Vakuumröhre eine Sensorik zur Erfassung des Sonnenstandes und zur entsprechenden Ansteuerung der Schrittmotore eine Steuereinheit vorhanden ist. Auch ist es von Vorteil, wenn für den Antrieb der Stellmotore zusätzliche Photovoltaikmodule vorhanden sind.

Eine vorteilhafte Ausführungsform wird erhalten, wenn zur Verbesserung der Energiegewinnung, Warmwasser oder Strom, unterhalb des Kombi-Solarkollektors ein Parabolspiegel auf einer Unterkonstruktion angebracht ist.

Die Erfindung betrifft auch eine Kombi-Solarkollektoranlage mit mehreren derartigen Kombi-Solarkollektoren, die nebeneinander angeordnet sind.

Die Erfindung wird nachfolgend anhand von in der Zeichnung gezeigten bevorzugten Ausführungsbeispielen noch weiter erläutert. Es zeigen:
Fig. 1 einen Querschnitt durch einen Kombi-Solarkollektor in vergrößertem Maßstab;
Fig. 2a einen Grundriss mit mehreren parallel angeordneten Kombi-Solarkollektoren sowie die Ausführung der Verdrehbarkeit mittels Schrittmotor, Sensorik zur Sonnenstanderfassung, und Photovoltaikmodulen für den Antrieb des Schrittmotors;
Fig. 2b eine Seitenansicht eines Kombi-Solarkollektors;
Fig. 3a die Betriebsstellung eines Kombi-Solarkollektoren zur Warmwassergewinnung sowie schematisch die nach dem Sonnenstand verlaufende Nachführung des Kombi-Solarkollektors, um die höchste Energieausbeute für diesen Betriebszustand zu erwirken;
Fig. 3b die Betriebsstellung des Kombi-Solarkollektors zur Stromgewinnung sowie schematisch die nach dem Sonnenstand verlaufende Nachführung des Kombi-Solarkollektors, um die höchste Energieausbeute für diesen Betriebszustand zu erwirken;
Fig. 3c zeigt Kombi-Solarkollektoren in der Betriebsstellung der Warmwassergewinnung sowie zur Verbesserung der Strom-Energiegewinnung auf einer Unterkonstruktion angebrachte Parabolspiegel; und
Fig. 4 zeigt ein Schaltbild für eine Gesamtanlage, wobei durch eine Steuereinheit das Energiemanagement der Anlage gesteuert wird.

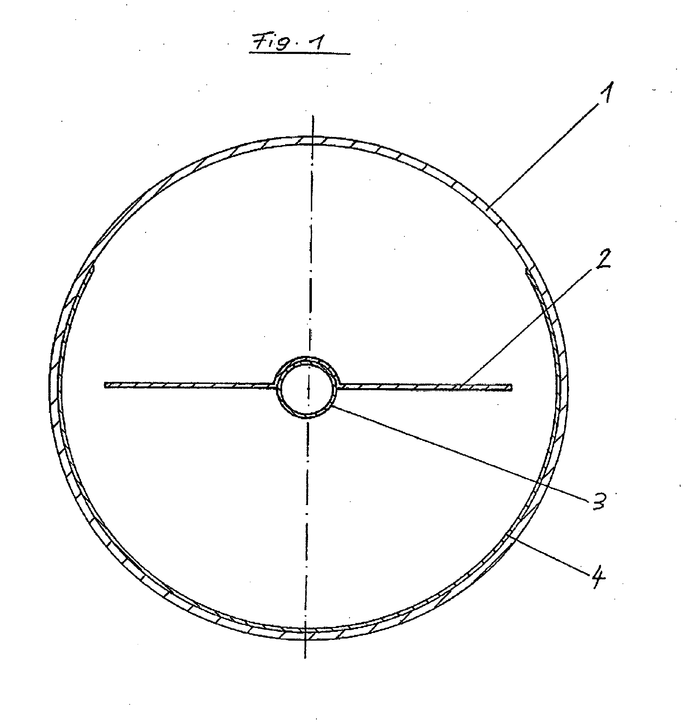

In Fig. 1 ist dargestellt, dass der Kombi-Solarkollektor im Prinzip wie ein handelsüblicher Vakuumröhrenkollektor aufgebaut ist. In einer transparenten Vakuumröhre 1 befindet sich ein Absorberblech 2 mit einem daran angebrachten, von einem Fluid durchströmbaren Wärmerohr 3.

Zusätzlich ist an der Innenseite der Vakuumröhre 1 ein Photovoltaikelement 4 im Dünnschichtverfahren, in Dünnschichtmodulbauweise, aufgebracht. Damit ist für die Integrierung des Photovoltaikelement 4 kein zusätzliches Bauelement, gegenüber handelsüblichen Vakuumröhrenkollektoren, erforderlich, da die Aufbringung mittels Aufdampfen auf die Innenseite der Glasröhre 1 erfolgt. Ein solches Photovoltaikelement 4 erreicht auch einen guten Wirkungsgrad bei diffusem Licht.

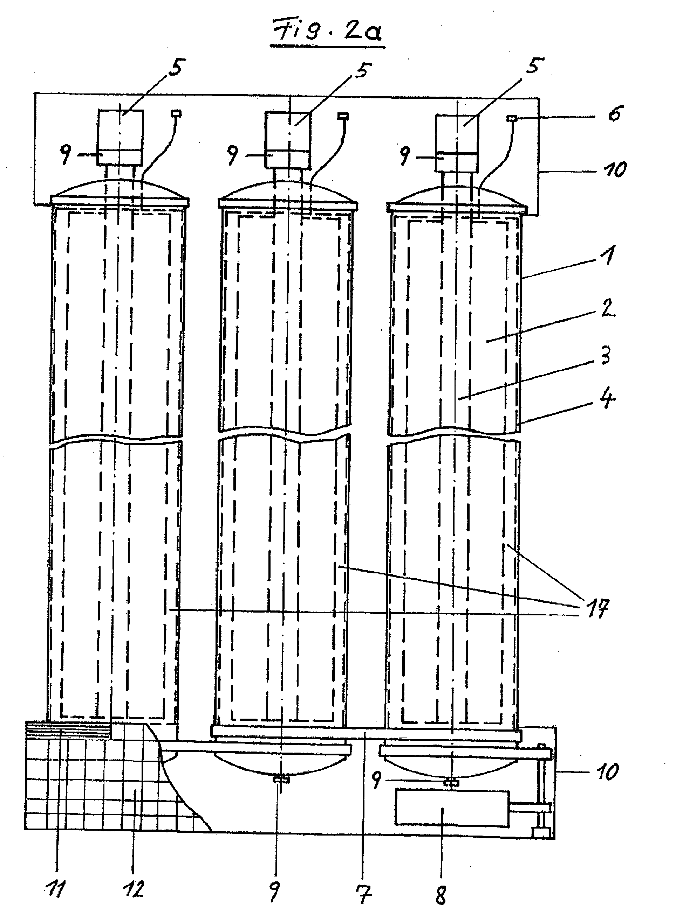

In Fig. 2a sind mehrere parallel zueinander angeordnete Kombi-Solarkollektoren zu einer Kombi-Solarkollektoranlage 17 vereint dargestellt. Die einzelnen Kombi-Solarkollektoren sind drehbar gelagert s. die schematisch angeordneten Lager 9, und sie werden mittels Stellmotor 8 mit Riemenantrieb 7 über eine externe Stromversorgung in den jeweils erforderlichen oder gewünschten Betriebszustand verdreht und dem Sonnenstand, welcher mittels einer Sensorik 11 erfasst wird, nachgeführt.

Ist keine externe Stromversorgung vorgesehen, bzw. bei der Nachrüstung von bestehenden Vakuumröhrenkollektorenanlagen, ist in die Verdreheinheit, bestehend aus Motor 8, Riemenantrieb 7 und Sensorik 11, in deren Verkleidung 10 ein Photovoltaikmodul 12 integriert, welches zur Energiegewinnung für die Verdrehung des Stellmotors 8 zuständig ist. Die Auskoppelung der erzeugten Wärmeenergie erfolgt mittels einer Steckhülse für die Koppelung an einen Kondensator 5 in einen Wärmetauscher (in der Zeichnung nicht dargestellt).

Die Auskoppelung des erzeugten Stroms erfolgt mittels einer Steckverbindung 6.

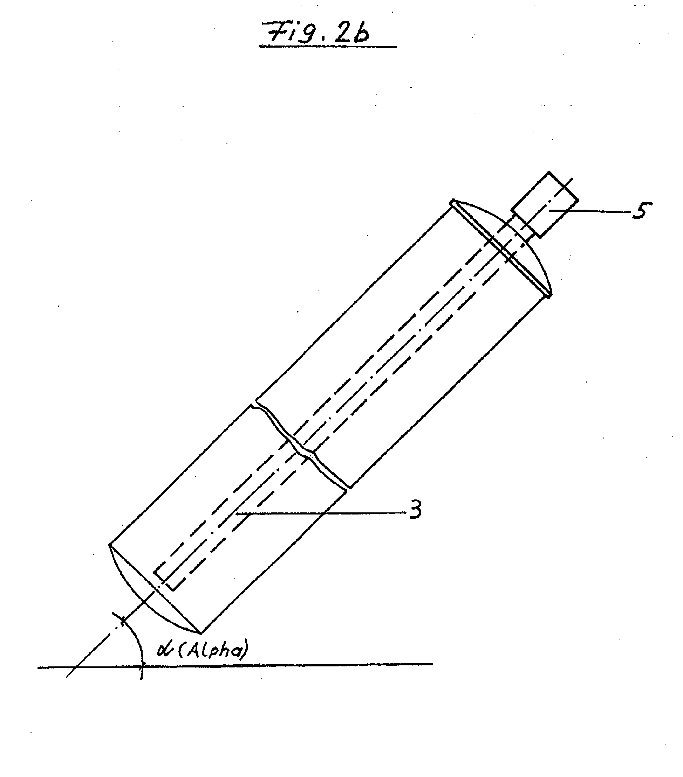

In Fig. 2b ist dargestellt, dass die Kombi-Solarkollektoren bevorzugt schräg in einem Winkel α (Alpha) größer oder gleich 25° angeordnet sind, sodass sich im Wärmerohr 3 eine thermisch bedingte Konvektionsströmung einstellt (Heatpipe). Die Wärmeauskoppelung erfolgt über den Kondensator 5. Es ist daher auch möglich, dass die Durchströmung des Wärmerohres 3 mit Hilfe einer Umwälzpumpe erfolgt.

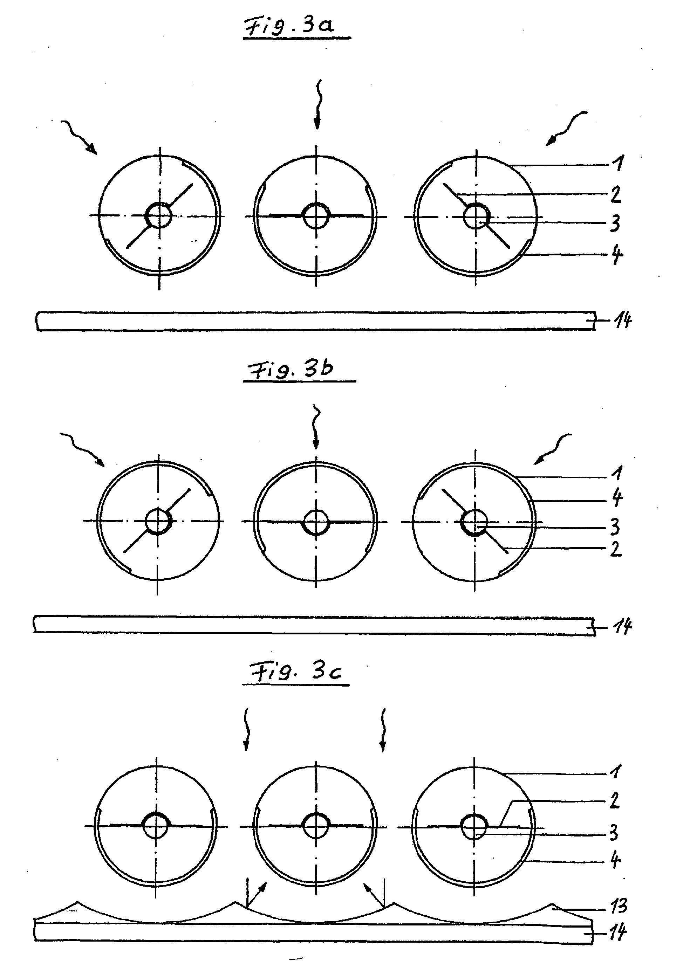

In Fig. 3a ist die Betriebstellung zur maximalen Energieausbeute bei der Warmwassergewinnung dargestellt. Das Absorberblech 2 mit dem daran angebrachten, von einem Fluid durchströmbaren Wärmerohr 3 wird dem Sonnenstand entsprechend optimal ausgerichtet, sodass das Absorberblech 2 vollflächig von den Sonnenstrahlen beaufschlagt wird. Das Photovoltaikelement 4 ist dabei vom Absorberblech 2 abgeschattet.

In Fig. 3b ist die Betriebstellung zur maximalen Energieausbeute bei der Stromgewinnung dargestellt. Das Photovoltaikelement 4 wird, dem Sonnenstand entsprechend, optimal ausgerichtet und von den Sonnenstrahlen vollflächig beaufschlagt. Das Absorberblech 2 ist dabei vom Photovoltaikelement 4 abgeschattet. Zusätzlich ist der Vorteil des Photovoltaikelements 4 in Dünnschichtmodulbauweise der, dass dieses am Innendurchmesser des Glaszylinders der Vakuumröhre 1 aufgedampft wird. Damit ist einerseits kein zusätzlicher Baukörper für die Aufdampfung des Dünnschichtmoduls erforderlich, und andererseits wird eine Flächenvergrößerung des Photovoltaikelements 4 gegenüber einer Aufdampfung auf eine gerade Fläche erreicht. Photovoltaikelemente als Dünnschichtmodul haben auch den Vorteil, diffuses Licht zur Energiegewinnung nutzen zu können.

Aus Fig. 3c ist ersichtlich, dass im Bereich einer Unterkonstruktion 14 ein Parabolspiegel 13 angebracht ist, um eine Verstärkung der Energieausbeute, für die dem einfallenden Sonnenlicht abgewandten Kollektorseite, zu erreichen.

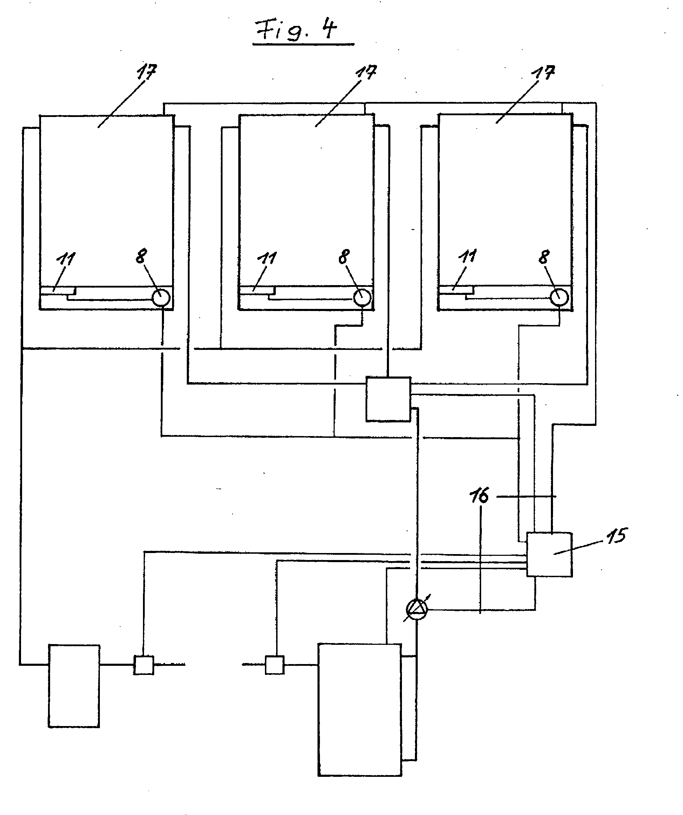

In Fig. 4 ist dargestellt, dass Kombi-Solarkollektoren zumindest zu einer Kombi-Solarkollektoranlage 17 zusammengefasst sind, und mittels einer Steuereinheit 15 und Steuerleitungen 16 werden die einzelnen Kombi-Solarkollektoranlagen 17, je nach Betriebszustand, dem Sonnenstand entsprechend, mittels der Sensorik 11 und dem Stellmotor 8 nachgeführt, betrieben.

Diese Schaltung hat unter anderem den großen Vorteil, dass einzelne Kombi-Solarkollektoranlagen 17 im Betriebszustand "Stromgewinnung" und die übrigen Kombi-Solarkollektoranlagen 17 in der Betriebsstellung "Warmwassergewinnung" betrieben werden können.

Damit ist gegenüber handelsüblichen Vakuumröhrenkollektoren der Vorteil gegeben, dass keine Überhitzung des Warmwassers erfolgen kann, da, falls genügend Warmwasser produziert wurde, durch die Steuereinheit 15 die Kombi-Solarkollektoranlage 17 in den Betriebszustand der Stromgewinnung gebracht werden kann.

Falls keine lokale Stromabnahme vorhanden ist, wird die Überproduktion in das öffentliche Stromnetz gegen Entgelt eingespeist.

Handelsübliche Vakuumröhrenkollektoren, die ohne Verdrehbarkeit ausgestattet sind, sind meist jene, die nur zur Warmwassergewinnung und Heizungsunterstützung konzipiert sind.

Für die Heizungsunterstützung haben diese Kollektoren aber den Nachteil, dass in der kalten Jahreszeit ein Bedecken der Vakuumröhrenkollektoren mit Schnee erfolgen kann, sodass dann aber keine Sonneneinstrahlung auf die Vakuumröhre mehr erfolgt.

Ein Vorteil der Verdrehbarkeit des Kombi-Solarkollektors liegt darin, dass beim Vorhandensein keiner oder nur geringer Sonneneinstrahlung, der Solarkollektor in den Betriebzustand Stromgewinnung gedreht werden kann, und falls eine Bedeckung mit Schnee erfolgt, hat diese für die Betriebsstellung Warmwassergewinnung keinen negativen Einfluss. Bei einer Ausführung des Stellmotors 8 mittels Federrücklauf kann im Falle eines Stromausfalles die Verdrehung des Kombi-Solarkollektors in eine definierte Stellung (z.B. Stromgewinnung) bewirkt werden.

Zusätzlich zu der effizienten Energiegewinnung bietet dieser Kollektortyp den Vorteil eines einheitlichen Erscheinungsbildes und die Erreichung eines Plus-Energie-Hauses (Objekt, welches mehr Energie erzeugt, als in diesem Objekt in Form von Warmwasser oder Strom verbraucht wird).

## Patentansprüche

1. Kombi-Solarkollektor mit einem evakuierten Gehäuse, in dessen gemeinsamen Innenraum sich ein Absorberblech (2) mit einem daran angebrachten, von einem Fluid durchströmbaren Wärmerohr und ein Photovoltaikelement (4) befinden, wobei das Photovoltaikelement (4) an der Innenseite einer Wand des Gehäuses angeordnet ist, **dadurch gekennzeichnet, dass** das Gehäuse durch eine drehbar gelagerte Glaszylinder-Vakuumröhre (1) gebildet ist, an deren Innenseite das Photovoltaikelement (4) in einer zylindrischen Form unter Freilassung eines Umfangbereichs angeordnet ist.

2. Kombi-Solarkollektor nach Anspruch 1, **dadurch gekennzeichnet, dass** das Photovoltaikelement (4) durch ein Dünnschichtmodul gebildet ist.

3. Kombi-Solarkollektor nach Anspruch 1 oder 2, **dadurch gekennzeichnet, dass** zur Verdrehung der Vakuumröhre (1) ein Schrittmotor (8) als Stellmotor angeordnet ist.

4. Kombi-Solarkollektor nach Anspruch 3, **dadurch gekennzeichnet, dass** zur Steuerung der Verdrehung der Vakuumröhre (1) eine Sensorik (11) zur Erfassung des Sonnenstandes und zur entsprechenden Ansteuerung des Schrittmotors eine Steuereinheit (15) vorhanden ist.

5. Kombi-Solarkollektor nach Anspruch 3, **dadurch gekennzeichnet, dass** für den Antrieb des Schrittmotors (8) zusätzliche Photovoltaikmodule (12) vorhanden sind.

6. Kombi-Solarkollektor nach Anspruch 1, **dadurch gekennzeichnet, dass** zur Verbesserung der Energiegewinnung, Warmwasser oder Strom, unterhalb der Vakuumröhre (1) ein Parabolspiegel (13) auf einer Unterkonstruktion (14) angebracht ist.

7. Kombi-Solarkollektoranlage (17) **dadurch gekennzeichnet, dass** mehrere Kombi-Solarkollektoren gemäß einem der Ansprüche 1 bis 6 nebeneinander angeordnet sind.

## Claims

1. A combined solar collector with an evacuated housing, having disposed in the joint inner space thereof an absorber sheet (2) with a heat tube attached thereon and adapted to be flown through by a fluid, and a photovoltaic element (4), wherein the photovoltaic element (4) is arranged at the inner side of a wall of the housing, **characterized in that** the housing is formed by a rotatably mounted glass cylinder vacuum tube (1) at the inner side of which the photovoltaic element (4) is arranged in a cylindrical shape, leaving open a circumferential region.

2. The combined solar collector of claim 1, **characterized in that** the photovoltaic element (4) is formed by a thin layer module.

3. The combined solar collector of claims 1 or 2, **characterized in that** a step motor (8) as a servomotor is arranged for rotating the vacuum tube (1).

4. The combined solar collector of claim 3, **characterized in that**, for controlling the rotation of the vacuum tube (1), a sensor system (11) is provided for detecting the position of the sun, and a control unit (5) is provided for the appropriate triggering of the step motor.

5. The combined solar collector of claim 3, **characterized in that** additional photovoltaic modules are provided for driving the step motor.

6. The combined solar collector of claim 1, **characterized in that**, for improving the production of energy, hot water or current, a parabolic mirror (13) is arranged on a substructure (14) below the vacuum tube (1).

7. A combined solar collector system (17), **characterized in that** a plurality of combined solar collectors according to any of claims 1 to 6 are arranged side by side.

## Revendications

1. Collecteur solaire combiné avec un boîtier évacué, dans l'espace intérieur commun duquel se trouvent une tôle d'absorption (2) avec un tube thermique, monté sur celle-ci et pouvant être traversé par un fluide, et un élément photovoltaïque (4), cet élément photovoltaïque (4) étant disposé sur le côté intérieur d'une paroi du boîtier , **caractérisé en ce que** le boîtier est constitué d'un tube à vide à cylindre en verre (1), à l'intérieur duquel est disposé l'élément photovoltaïque (4) dans une forme cylindrique avec le dégagement d'une zone périphérique.

2. Collecteur solaire combiné selon la revendication 1, **caractérisé en ce que** l'élément photovoltaïque (4) est constitué d'un module à couche mince.

3. Collecteur solaire combiné selon la revendication 1 ou 2, **caractérisé en ce que**, pour la rotation du tube à vide (1), un moteur pas-à-pas (8) est prévu en tant que servomoteur.

4. Collecteur solaire combiné selon la revendication 3, **caractérisé en ce que**, pour le contrôle de la rotation du tube à vide (1), des capteurs (11) sont prévus pour la mesure de la position du soleil et, pour la commande correspondante du moteur pas-à-pas, une unité de commande (15) est prévue.

5. Collecteur solaire combiné selon la revendication 3, **caractérisé en ce que**, pour l'entraînement du moteur pas-à-pas (8), des modules photovoltaïques (12) supplémentaires sont prévus.

6. Collecteur solaire combiné selon la revendication 1, **caractérisé en ce que**, pour améliorer la production d'énergie, d'eau chaude ou de courant, un miroir parabolique (13) est monté sur une infrastructure (14) en dessous du tube à vide (1).

7. Installation à collecteur solaire combiné (17) **caractérisée en ce que** plusieurs collecteurs solaires combinés selon l'une des revendications 1 à 6 sont disposés les uns à côté des autres.
